# EUROPÄISCHE PATENTSCHRIFT

(11) **EP 0 358 042 B1**
(45) Veröffentlichungstag und Bekanntmachung des Hinweises auf die Patenterteilung: **06.12.1995**
(21) Anmeldenummer: 89115505.3
(22) Anmeldetag: 23.08.1989
(51) Int. Cl.: H01L 21/28

(54) **Selbstjustierendes Verfahren zur Herstellung einer Steuerelektrode**
Self-aligned process for manufacturing a gate electrode
Procédé autoaligné pour la fabrication d'une électrode de porte

(30) Priorität: 07.09.1988 DE 3830302; 08.04.1989 DE 3911512
(43) Veröffentlichungstag der Anmeldung: 14.03.1990
(73) Patentinhaber: Licentia Patent-Verwaltungs-GmbH, 60596 Frankfurt (DE); TEMIC TELEFUNKEN microelectronic GmbH, 74072 Heilbronn (DE)
(72) Erfinder: Dickmann, Jürgen, Dipl.-Ing., D-7900 Ulm-Einsingen (DE)
(74) Vertreter: Weber, Gerhard, Dipl.-Phys.

(56) Entgegenhaltungen:
- EP-A- 0 128 751
- US-A- 4 341 850
- US-A- 4 616 400
- US-A- 4 670 090
- JOURNAL OF VACUUM SCIENCE & TECHNOLOGY, Band 5, Nr. 1, Teil B, Januar-Februar 1987, Seiten 215-218, American Vacuum Society, Woodbury, NY, US ; S.W. PANG et al. : "Masked ion beam lithography for submicrometer-gate-length transistors"
- ELECTRONICS LETTERS, Band 18, Nr. 3, 4. Februar 1982, Seiten 119-121 ; K. YAMASAKI et al. : "Self-align implantation for n+-layer technology (saint) for high-speed GaAs ICs"

## Beschreibung

Die Erfindung betrifft ein selbstjustierendes Verfahren zur Herstellung einer Steuerelektrode nach dem Oberbegriff des Patentanspruchs 1.

Das Verfahren findet insbesondere Verwendung bei der Herstellung von Feldeffekttransistoren für analoge Anwendungen, die mit einer Schottky-Elektrode gesteuert werden.

In der US-A-4,670,090 ist ein Verfahren zur Herstellung eines Feldeffekt-Transistors beschrieben, bei welchem auf eine Bauelementoberfläche zwei Schichten verschiedener Photolacke aufgebracht werden. In der oberen Photolackschicht werden Fenster entsprechend der vorgesehenen Position von Source- und Drain-Anschlüssen freigelegt. Die so strukturierte obere Photolackschicht dient als Maske für die Belichtung der unteren Photolackschicht, in welcher nach überbelichtung Gräben mit seitlicher Unterschneidung der oberen Photolackschichten geätzt werden, und als Maske für die Abscheidung der Source- und Drain-Anschlüsse dienen. Durch die Unterschneidung bei der Grabenätzung ergibt sich selbstjustierend ein Dummy-Gate, welches in einem späteren Prozeßschritt entfernt wird und an dessen Stelle eine metallische Steuerelektrode erzeugt wird.

Aufgabe der vorliegenden Erfindung ist es, vorteilhafte selbstjustierende Verfahren zur Herstellung einer Steuerelektrode anzugeben.

Erfindungsgemäße Verfahren sind in den Patentansprüchen 1 und 2 beschrieben. Die Unteransprüche enthalten vorteilhafte Ausgestaltungen und Weiterbildungen der Erfindung.

Die Verfahren gemäß der Erfindung haben insbesondere den Vorteil, daß durch die Verwendung von lediglich zwei unterschiedlichen Materialien zur Strukturierung der Topologie, wobei sich die Materialien selektiv strukturieren lassen, der Prozeß sehr anwenderfreundlich wird.

Die Erfindung wird im folgenden anhand von Ausführungsbeispielen beschrieben unter Bezugnahme auf schematische Zeichnungen.

Die FIG. 1 bis 7 zeigen einen ersten Verfahrensablauf zur Herstellung der Gate-Elektrode.

FIG. 8 bis 11 zeigen eine erste Variante des Herstellungsprozesses der Gate-Elektrode.

FIG. 12 bis 15 zeigen eine zweite Variante des Herstellungsprozesses der Gate-Elektrode.

Das erfindungsgemäße Verfahren beginnt nach der Herstellung der Schichtenfolge für den Feldeffekttransistor und der Bauelementeisolation (Mesaätzung oder Ionenimplantation).

Auf der Oberfläche der Bauelementschichtenfolge 1 wird eine erste Strukturierungsschicht 2, z.B. eine homogene 0,5 »m dicke Germanium-Schicht aufgetragen. Anschließend wird eine dünne Fotolackschicht 3, z.B. Az 4040 oder PMMA, aufgeschleudert. Es folgt das Belichten und Entwickeln des Fotolackes und reaktives Ätzen der darunterliegenden ersten Strukturierungsschicht 2 aus Germanium durch Plasmaätzen mit z.B. CF₄ + 3% 0₂ im Barrelreaktor. Durch das Einstellen der lateralen Unterätzung der ersten Struktierungsschicht 2 wird
1. der für den Lift-off-Prozeß nötige Fotolacküberhang eingestellt und
2. die Breite des Dummy-Gates, bestehend aus einer schmalen Zone 2a der ersten Strukturierungsschicht 2, definiert.

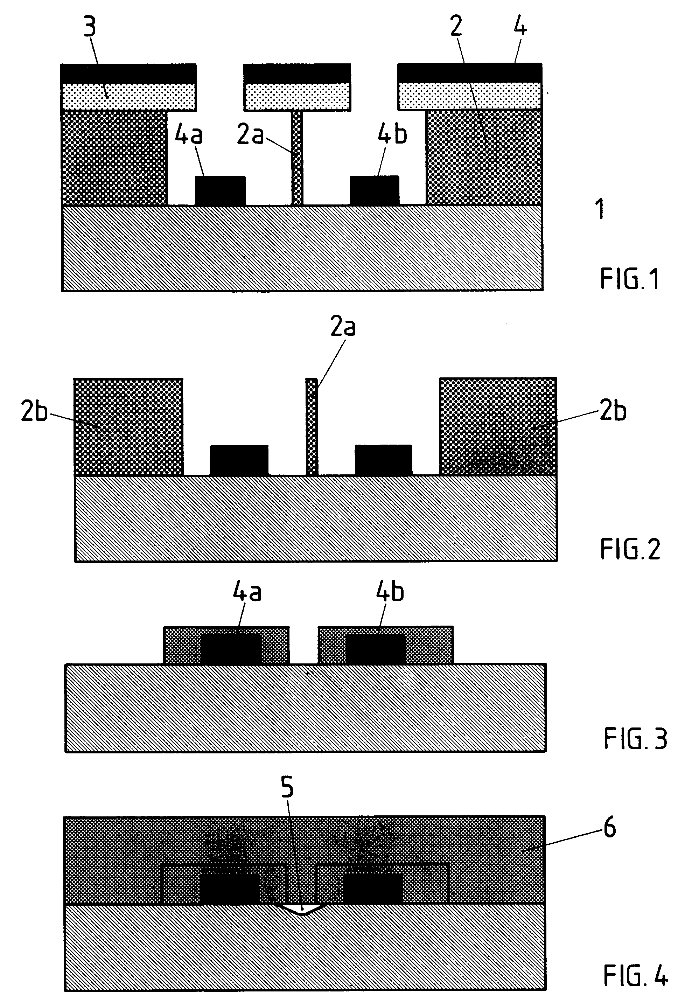

Danach wird eine Metallschicht 4 ganzflächig aufgedampft. Durch den Überhang der Fotolackschicht 3 werden die ohmschen Source- und Drainkontakte 4a, 4b auf der Bauelementoberfläche ausgebildet (FIG. 1). Mit einem Lift-off-Verfahren werden die Metall- und Fotolackschicht 3, 4 entfernt. Als weitere Verfahrensschritte folgen (Legieren der ohmschen Kontakte 4a, 4b) ganzflächige Abscheiden einer dünnen Isolationsschicht von z.B. ca. 0,3 »m dicken SiOx (FIG. 2), anschließendes Freiätzen der Seitenwände des Dummy-Gates 2a und der Germanium-Stempel 2b im 0₂-Plasma, beispielsweise durch RIE (Reactive Ion Etching) oder im Barrelreaktor, sowie das Entfernen des Dummy-Gates 2a und der Germanium-Stempel 2b durch (CF₄+3%0₂)-Plasmaätzen im Barrelreaktor (Fig. 3).

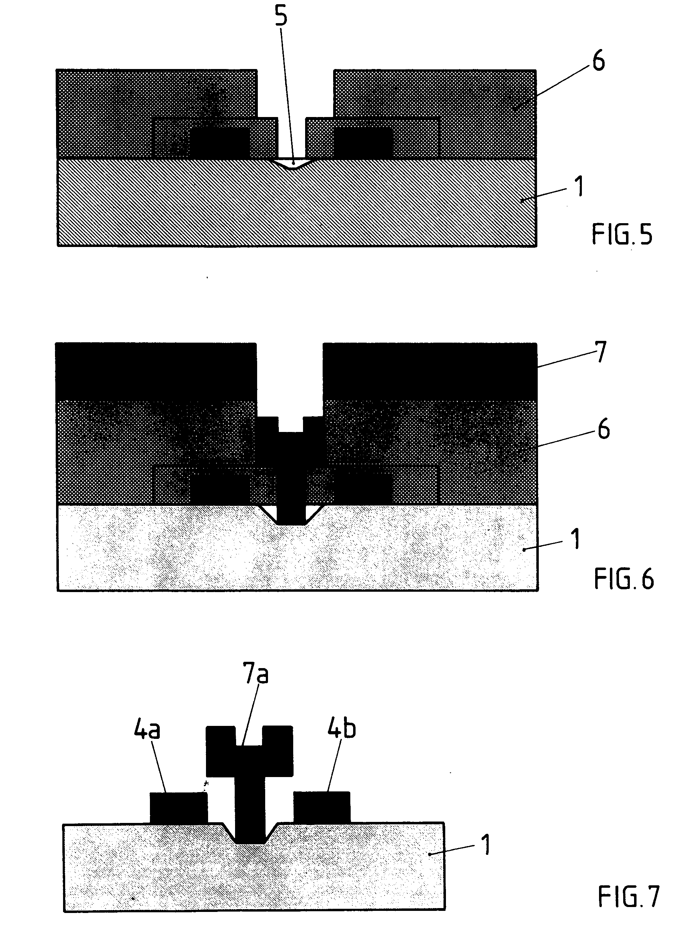

Durch einen naßchemischen Ätzprozeß in der obersten Schicht der Bauelementschichtenfolge 1 wird die angestrebte Kanaldicke bzw. Position 5 des Gates eingestellt (Gate-Recessing). Eine dicke Fotolackschicht 6 von ca. 1,2 »m wird anschließend auf die Bauelementoberfläche aufgeschleudert (FIG. 4). Belichten und Entwickeln des Fotolackes mit einer Maske, deren Strukturbreite größer ist als die Breite des Dummy-Gates ergeben die in FIG. 5 dargestellte T-förmige Gate-Struktur.

Danach wird eine Gate-Metallschicht 7 aus z.B. Al, Cr/Au, Ti/Pt/Au, mit einer Schichtdicke von ca. 0,4 - 0,6 »m aufgedampf. Durch ein Lift-off-Verfahren wird die auf der Fotolackschicht 6 aufgebrachte Gate-Metallschicht 7 entfernt. Die restliche Fotolackschicht 6 wird im 0₂-Plasma beseitigt. Anschließend werden die Kontakte 4a, 4b, 7a durch Elektroplatieren verstärkt (FIG. 7).

Das soweitbeschriebene Verfahren ist ähnlich dem aus der eingangs genannten US-A- 4 670 090 bekannten Verfahren und nicht Gegenstand des vorliegenden Patents.

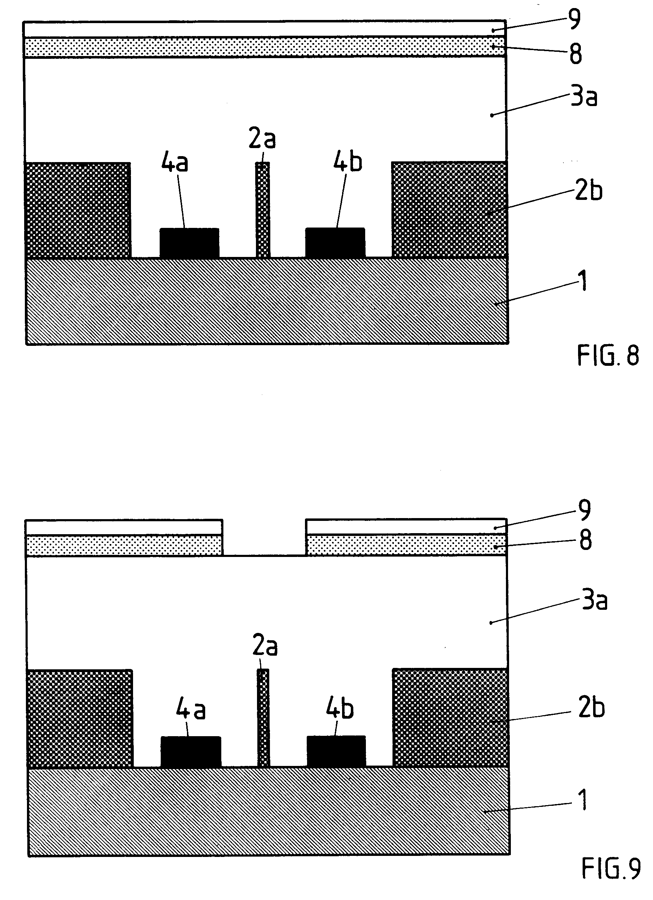

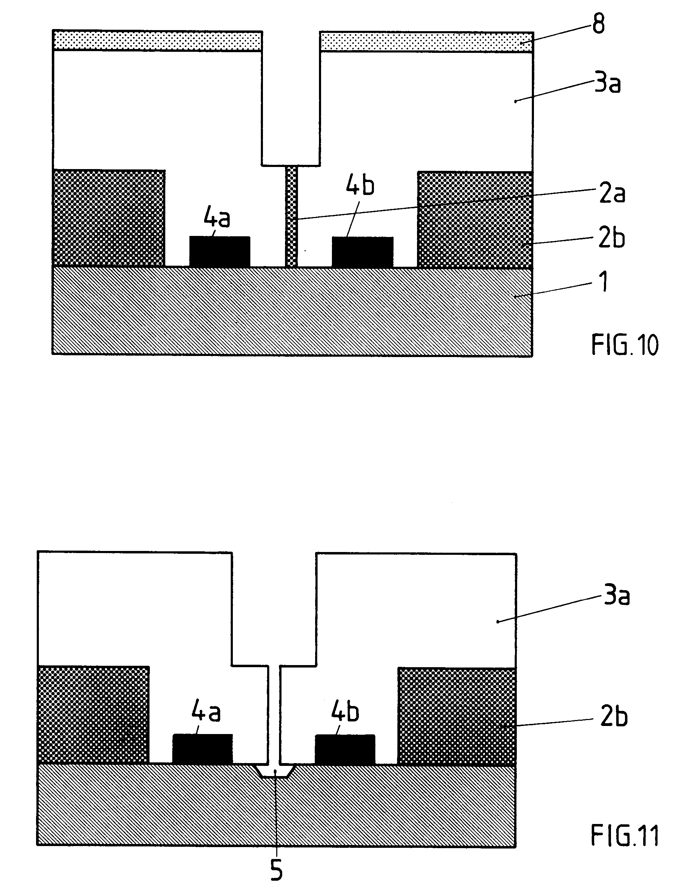

Eine erste Ausfuhrungsform des erfindungsgemäßen selbstjustierenden Prozeßablaufes geht aus von dem in FIG. 2 dargestellten Verfahrensstand. Auf die Bauelementoberfläche wird gemäß FIG. 8 eine Fotolackschicht 3a mit einer Schichtdicke von ca. 1,2 »m aufgebracht. Darauf wird eine zweite Strukturierungsschicht 8, z.B. aus Germanium, mit einer Schichtdicke von ungefähr 10 nm aufgedampft. Auf der Ge-Schicht wird eine dünne Fotolackschicht 9 aufgeschleudert (FIG. 8). Anschließend wird die obere Fotolackschicht 9 belichtet und entwickelt. Die darunterliegende zweite Strukturierungsschicht 8, die Ge-Schicht, wird mit CF₄ + 3% O₂ plasmageätzt (FIG. 9). Durch O₂-Plasmaätzen der unteren Fotolackschicht 3a wird ein Graben mit einer Breite von weniger als 1 »m und einer Tiefe bis zum Dummy-Gate 2a erzeugt (FIG. 10). Anschließend wird das Dummy-Gate 2a und die zweite Strukturierungsschicht 8 im (CF₄+3%O₂)-Plasma weggeätzt. Die Kanalbreite bzw. Position 5 des Gates wird durch einen Recessing-Prozeß in der obersten Schicht der Bauelementschichtenfolge 1 festgelegt (FIG. 11). Die weiteren Verfahrensschritte sind entsprechend dem vorher beschriebenen und in den FIG. 6, 7 dargestellten Verfahrensablauf zu entnehmen.

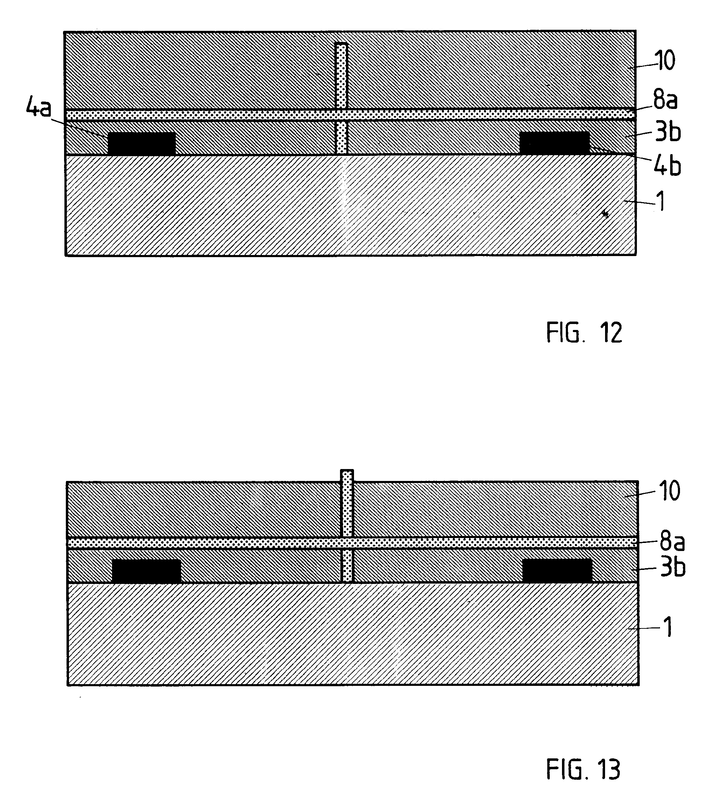

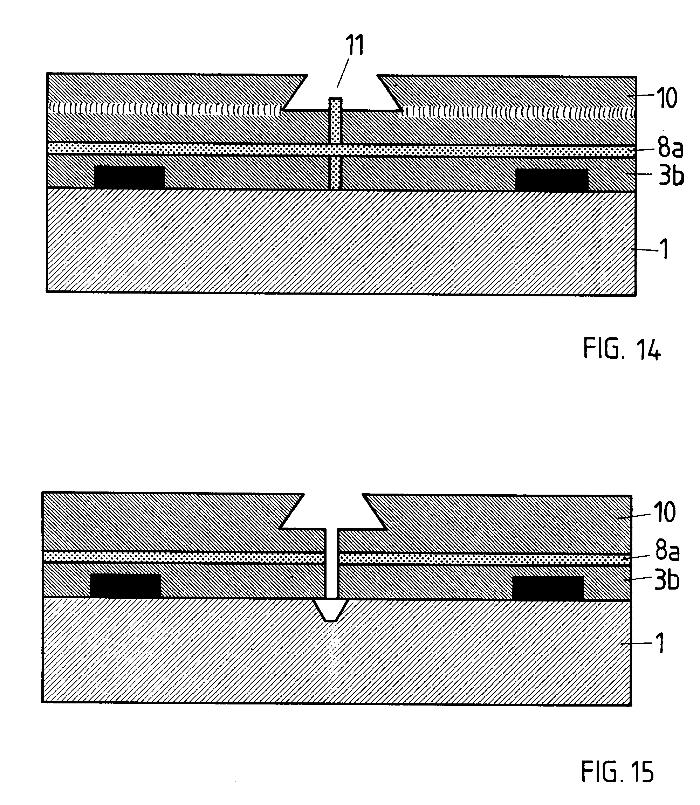

Eine zweite Ausführungsform des erfindungsgemäßen Verfahrens beginnt nach der Herstellung der ohmschen Kontakte (FIG. 3). Auf die Bauelementoberfläche wird gemäß FIG. 12 eine Schichtenfolge aufgebracht aus einer dünnen unteren Fotolackschicht 3b, z.B. aus Az 4040, einer zweiten Strukturierungsschicht 8a aus z.B. Germanium mit einer Schichtdicke von 20 nm und einer oberen Fotolackschicht 10 aus z.B. Az 4110 bei 400 U/min, deren Schichtdicke derart zu wählen ist, daß das Dummy-Gate 2a jedoch bedeckt wird. Durch anschließendes anisotropes O₂-Plasmaätzen (RIE) wird die obere Fotolackschicht 10 gedünnt, so daß das Dummy-Gate freiliegt (FIG. 13). Danach wird durch isotropes Cu-Ätzen das Dummy-Gate abgeätzt, und durch O₂-Plasmaätzen werden negative Fotolackkanten in der oberen Fotolackschicht 10 erzeugt. Es entsteht ein trapezförmiger Graben 11 in der oberen Fotolackschicht 10 (FIG. 14). Das restliche Dummy-Gate 2a wird durch Plasmaätzen mit z.B. CF₄ + 3% O₂ bis auf die Bauelementschichtenfolge 1 entfernt. Durch einen Recessing-Prozeß werden in der obersten Schicht der Bauelementschichtenfolge 1 die Gate-Position und die Gate-Kanalbreite festgelegt. Die weiteren Verfahrensschritte zur Herstellung der Gate-Elektrode werden, wie oben beschrieben und in den FIG. 6, 7 dargestellt, durchgeführt.

Bei dem erfindungsgemäßen Verfahren können für die Strukturierungsschichten 6, 8 anstelle von Germanium dielektrische Materialien verwendet werden, die sich materialselektiv gegenüber Fotolacken plasmaätzen lassen. Als Ätzen sind CF₄ oder CHF₃ oder SF₆ verwendbar.

Durch die selbstjustierenden Prozesse sind ein kleiner Drain-Source-Abstand von ca. 1 »m und eine Gate-Elektrode 7a mit einer Elektrodenlänge von ungefähr o,15 - 0,8 »m und einer Elektrodenhöhe von >0,8»m herstellbar. Dabei ist es vorteilhaft, daß bei einer kleinen Gatelänge das Verhältnis von Höhe/Länge der Gate-Elektrode groß ist. Dadurch wird günstigerweise der Zuleitungswiderstand der Gate-Elektrode (Gatewiderstand) reduziert und die Stromverstärkung des Transistors und dessen maximale Grenzfrequenz erhöht, ferner wird eine Reduzierung der minimalen Rauschzahl erreicht.

Die Herstellung der Gate-Elektrode und der ohmschen Kontakte für Source- und Drainanschluß kann auch durch eine Metallbedampfung, die in einem Winkel schräg zur Bauelemtenoberfläche durchgeführt wird, erfolgen. Dadurch wird in vorteilhafterweise der parasitäre Sourcewiderstand reduziert.

Durch das erfindungsgemäße, selbstjustierende Verfahren lassen sich ohne Einsatz eines Elektronenstrahlschreibers Submikrometer-Gates bis zu 0,15 »m herstellen.

## Patentansprüche

1. Selbstjustierendes Verfahren zur Herstellung einer Steuerelektrode, insbesondere Schottky-Gate-Kontakten, unter Verwendung eines Dummy-Gates, wobei zur Erzeugung des Dummy-Gates
- auf eine Halbleiterschichtenfolge (1) eine erste Strukturierungsschicht (2) aufgebracht und mit einer ersten Photolackschicht abgedeckt wird
- durch Belichten und Entwickeln des Photolacks und anschließendes Ätzen in der ersten Strukturierungsschicht zwei Gräben mit lateraler Unterätzung erzeugt werden derart, daß eine schmale Zone (2a) zwischen den Gräben als Dummy-Gate bestehen bleibt
und wobei in den Gräben und definiert durch den Überhang der Photolackschicht mittels eines Metallisierungsprozesses ohmsche Kontakte (4a, 4b) als Source- und Drain-Anschlüsse hergestellt werden und nach Entfernen des Dummy-Gates die Steuerelektrode an dessen Position hergestellt wird, dadurch gekennzeichnet, daß nach dem Herstellen der ohmschen Kontakte für Source- und Drain-Anschlüsse
- auf die Bauelementoberfläche eine Schichtenfolge bestehend aus einer dicken Fotolackschicht (3a), einer zweiten Strukturierungsschicht (8) und einer dünnen Fotolackschicht (9) aufgebracht wird,
- ein Graben in die Schichtenfolge geätzt wird, dessen Breite dem Abstand der ohmschen Kontakte (4a, 4b) für den Source- und Drainanschluß entspricht und der bis zu schmalen Zone (2a) der ersten Strukturierungsschicht reicht
- die schmale Zone (2a) der ersten Strukturierungsschicht entfernt wird,
- durch einen Recessing-Prozeß in der obersten Schicht der Halbleiterschichtenfolge (1) die Kanaldicke und die Position des Gates festgestellt wird, und
- durch Aufdampfen einer Gate-Metallschicht (7) und Entfernen der Gate-Metallschicht (7) auf der dicken Fotolackschicht (3a) durch ein Lift-off-Verfahren eine T-förmige Gate-Elektrode hergestellt wird.

2. Selbstjustierendes Verfahren zur Herstellung einer Steuerelektrode, insbesondere Schottky-Gate-Kontakten, unter Verwendung eines Dummy-Gates, wobei zur Erzeugung des Dummy-Gates,
- auf eine Halbleiterschichtenfolge (1) eine erste Strukturierungsschicht (2) aufgebracht und mit einer ersten Photolackschicht abgedeckt wird
- durch Belichten und Entwickeln des Photolacks und anschließendes Ätzen in der ersten Strukturierungsschicht zwei Gräben mit lateraler Unterätzung erzeugt werden derart, daß eine schmale Zone (2a) zwischen den Gräben als Dummy-Gate bestehen bleibt
und wobei in den Gräben und definiert durch den Überhang der Photolackschicht mittels eines Metallisierungsprozesses ohmsche Kontakte (4a, 4b) als Source- und Drain-Anschlüsse hergestellt werden und nach Entfernen des Dummy-Gates die Steuerelektrode an dessen Position hergestellt wird, dadurch gekennzeichnet, daß nach der Herstellung der ohmsche Kontakte für Source- und Drain-Anschlüsse
- auf die Bauelementoberfläche eine Schichtenfolge aus einer dünnen unteren Fotolackschicht (3B), einer zweiten Strukturierungsschicht (8a) und einer oberen Fotolackschicht (10) aufgebracht wird, derart, daß die schmale Zone (2a) der Strukturierungsschicht (2) überdeckt wird,
- durch einen anschließenden Ätzprozeß die schmale Zone (2a) der Strukturierungsschicht (2) in der oberen Fotolackschicht (10) in einem trapezförmigen Graben (11) versenkt wird
- die schmale Zone (2a) der ersten Strukturierungsschicht entfernt wird
- durch einen Recessing-Prozeß in der obersten Schicht der Halbleiterschichtfolge (1) die Kanaldicke und die Position des Gates festgelegt wird, und
- durch Aufdampfen einer Gate-Metallschicht (7) und Entfernen der Gate-Metallschicht (7) auf der oberen Fotolackschicht (10) durch ein Lift-off verfahren eine T-förmige Gate-Elektrode hergestellt wird.

3. Verfahren nach einem der vorhergehenden Ansprüche, dadurch gekennzeichnet, daß für die Strukturierungsschichten (2, 8) Germanium oder dielektrische Materialien verwendet werden.

4. Verfahren nach einem der vorhergehenden Ansprüche, dadurch gekennzeichnet, daß das Metall zur Herstellung der ohmschen Kontakte (4a, 4b) für den Source- und Drainanschluß in einem Winkel schräg zur Bauelementoberfläche aufgedampft wird.

## Claims

1. Self-aligning method of manufacturing a control electrode, especially Schottky gate contacts, with use of a dummy gate, wherein for production of the dummy gate
- a first structuring layer (2) is applied to a semiconductor layer sequence (1) and is covered by a first photo-sensitive lacquer layer,
- through exposing the photo-sensitive lacquer to light, developing it and subsequent etching in the first structuring layer two trenches with lateral under-etching are produced in such a manner that a narrow zone (2a) is left between the trenches as a dummy gate,
and wherein resistive contacts (4a, 4b) as source and drain terminals are produced in the trenches and defined by the overhang of the photosensitive lacquer layer by means of a metallising process and after removal of the dummy gate the control electrode is produced at the position thereof, characterised thereby that after the production of the resistive contacts for source and drain terminals
- a layer sequence consisting of a thick photo-sensitive lacquer layer (3a), a second structuring layer (8) and a thin photosensitive lacquer layer (9) is applied to the component surface,
- a trench is etched in the layer sequence, the width of which corresponds to the spacing of the resistive contacts (4a, 4b) for the source and drain terminal and which reaches up to the narrow zone (2a) of the first structuring layer,
- the narrow zone (2a) of the first structuring layer is removed,
- the channel thickness and the position of the gate is established by a recessing process in the uppermost layer of the semiconductor layer sequence (1), and
- a T-shaped gate electrode is produced by vapour deposition of a gate metal layer (7) and removal of the gate metal layer (7) on the thick photo-sensitive lacquer layer (3a) by a lift-off process.

2. Self-aligning method of manufacturing a control electrode, especially Schottky gate contacts, with use of a dummy gate, wherein for production of the dummy gate
- a first structuring layer (2) is applied to a semiconductor layer sequence (1) and is covered by a first photo-sensitive lacquer layer,
- through exposing the photo-sensitive lacquer to light, developing it and subsequent etching in the first structuring layer two trenches with lateral under-etching are produced in such a manner that a narrow zone (2a) is left between the trenches as a dummy gate,
and wherein resistive contacts (4a, 4b) as source and drain terminals are produced in the trenches and defined by the overhang of the photosensitive lacquer layer by means of a metallising process and after removal of the dummy gate the control electrode is produced at the position thereof, characterised thereby that after the production of the resistive contacts for source and drain terminals
- a layer sequence of thin lower photo-sensitive lacquer layer (3B), a second structuring layer (8a) and an upper photo-sensitive lacquer layer (10) is applied to the component surface in such a manner that the narrow zone (2a) of the structuring layer (2) is covered,
- through a subsequent etching process the narrow zone (2a) of the structuring layer (2) is lowered into the upper photo-sensitive lacquer layer (10) in a trapezium-shaped trench (11),
- the narrow zone (2a) of the first structuring layer is removed,
- the channel thickness and the position of the gate is established by a recessing process in the uppermost layer of the semiconductor layer sequence (1), and
- a T-shaped gate electrode is produced by vapour deposition of a gate metal layer (7) and removal of the gate metal layer (7) on the upper photo-sensitive lacquer layer (10) by a lift-off process.

3. Method according to one of the preceding claims, characterised thereby that germanium or dielectric materials are used for the structuring layers (2, 8).

4. Method according to one of the preceding claims, characterised thereby that the metal for production of the resistive contacts (4a, 4b) for the source and drain terminal is vapour-deposited at an angle obliquely to the component surface.

## Revendications

1. Procédé à ajustage automatique pour la réalisation d'une électrode de commande, en particulier de contact de grille de Schottky, avec emploi d'une "Dummy-Gate", pour l'engendrement de la "Dummy-Gate" :
- une première couche de structuration (2) étant déposée sur une succession de couches de semi-conducteur (1) et étant recouverte avec une première couche de laque photosensible,
- par exposition à la lumière et développement de la laque photosensible et attaques consécutives dans la première couche de structuration, deux tranchées étant engendrées, avec des attaques par dessous latérales, de telle sorte, qu'une zone (2a) étroite reste subsistante entre les tranchées comme "Dummy-Gate",
et des contacts ohmiques (4a, 4b) étant réalisés comme des raccordements de source et de drain, dans les tranchées, et définis par le surplomb de la couche de laque photosensible au moyen d'un processus de métallisation, et, après enlèvement de la "Dummy-Gate", l'électrode de commande étant réalisée à la position de celle-ci, caractérisé en ce que, après la réalisation des contacts ohmiques pour raccordements de source et de drain :
- sur la surface de composant, une succession de couches, consistant en une couche de laque photosensible (3a) épaisse, une deuxième couche de structuration (8) et une couche de laque photosensible (9), est déposée,
- une tranchée est réalisée par attaque dans la succession de couches, dont la largeur correspond à l'espacement des contacts ohmiques (4a, 4b) pour le raccordement de source et de drain, et qui parvient jusqu'à la zone (2a) étroite de la première de structuration,
- la zone (2a) étroite de la première couche de structuration est enlevée,
- par un processus de "recessing", dans la couche supérieure de la succession de couches de semi-conducteur (1), l'épaisseur de canal et la position de la grille sont déterminées, et
- par dépôt par vaporisation d'une couche de métal de grille (7) et enlèvement de la couche de métal de grille (7), sur la couche de laque photosensible (3a) épaisse, grâce à un procédé d'enlèvement par soulèvement "Lift-off", une électrode de grille en forme de T est réalisée.

2. Procédé à ajustage automatique pour la réalisation d'une électrode de commande, en particulier de contacts de grille de Schottky, avec emploi d'une "Dummy-Gate", pour l'engendrement de la "Dummy-Gate" :
- une première couche de structuration (2) étant déposée sur une succession de couches de semi-conducteurs (1) et étant recouverte avec une première couche de laque photosensible,
- deux tranchées, avec des attaques par dessous latérales, étant engendrées, par exposition à la lumière et développement de la laque photosensible et attaque consécutive dans la première couche de structuration, de telle sorte, qu'une zone (2a) étroite reste subsistante entre les tranchées comme "Dummy-Gate",
et des contacts ohmiques (4a, 4b) étant réalisés comme des raccordements de source et de drain, dans les tranchées, et définis par le surplomb de la couche de laque photosensible au moyen d'un processus de métallisation, et, après enlèvement de la "Dummy-Gate", l'électrode de commande étant réalisée à la position de celle-ci, caractérisé en ce que, après la réalisation des contacts ohmiques pour raccordements de source et de drain :
- sur la surface de composant, une succession de couches, consistant en une couche de laque photosensible (3b) épaisse, une deuxième couche de structuration (8a) et une couche de laque photosensible (10), est déposée de telle sorte, que la zone (2a) étroite de la couche de structuration (2) est recouverte,
- grâce à un processus d'attaque consécutif, la zone (2a) étroite de la couche de structuration (2), dans la couche de laque photosensible (10) supérieure, est escamotée dans une tranchée (11) en forme de trapèze,
- la zone (2a) étroite de la première couche de structuration est enlevée,
- par un processus de "recessing", dans la couche supérieure de la succession de couches de semi-conducteur (1), l'épaisseur de canal et la position de la grille sont déterminées, et
- par dépôt par vaporisation d'une couche de métal de grille (7) et enlèvement de la couche de métal de grille (7), sur la couche de laque photosensible (10) supérieure, grâce à un procédé d'enlèvement par soulèvement "Lift-off", une électrode de grille en forme de T est réalisée.

3. Procédé selon une des précédentes revendications, caractérisé en ce que pour les couches de structurations (2, 8), du germanium ou des matériaux diélectriques sont employés.

4. Procédé selon une des précédentes revendications, caractérisé en ce que le métal, pour la réalisation des contacts (4a, 4b) ohmiques pour le raccordement de source et de drain, est déposé par vaporisation sous un angle incliné par rapport à la surface de composant.
